# EUROPEAN PATENT APPLICATION

(11) **EP 4 064 345 A1**
(43) Date of publication of application: **28.09.2022**
(21) Application number: 21163949.7
(22) Date of filing: 22.03.2021
(51) Int. Cl.: H01L 25/07, H01L 23/16

(54) **CHIP PACKAGE WITH POROUS ELASTICALLY DEFORMABLE LAYER**

(71) Applicant: Hitachi Energy Switzerland AG, 5400 Baden (CH)
(72) Inventor: DUGAL, Franc, 8121 Benglen (CH)
(74) Representative: Epping - Hermann - Fischer

(57) **Abstract**

In at least one embodiment, the chip package comprises:
- at least one first compensation layer (31) which is electrically conductive, and
- a plurality of semiconductor chips (2) arranged on and electrically contacted by the at least one first compensation layer (31),
wherein
- the at least one first compensation layer (31) comprises a plurality of pores (6), and
- the at least one first compensation layer (31) is elastically deformable so that the at least one first compensation layer (31) is configured to compensate for height differences (ΔH) between the semiconductor chips (2).

## Description

A chip package is provided.

Document US 6,320,268 B1 refers to a power semiconductor module in which at least one semiconductor chip with which contact is made by pressure is electrically connected via a contact element to a main connection.

A problem to be solved is to provide a chip package in which semiconductor chips can efficiently be mounted.

This object is achieved, inter alia, by a chip package as defined in the independent patent claim. Exemplary further developments constitute the subject-matter of the dependent claims.

For example, the chip package comprises an electrically conductive compensation layer which is mechanically elastically deformable. Thus, by means of the compensation layer height differences between semiconductor chips can be compensated for when the semiconductor chips are pressed onto, for example, a base plate by means of the compensation layer. Hence, a common compensation layer can be used for a plurality of semiconductor chips to press them onto the base plate without the need for individually assigning spring elements to each one of the semiconductor chips.

In at least one embodiment, the chip package comprises at least one first compensation layer which is electrically conductive, and a plurality of semiconductor chips arranged on and electrically contacted by the at least one first compensation layer. The at least one first compensation layer comprises a plurality of pores and is elastically deformable so that the at least one first compensation layer is configured to compensate for height differences between the semiconductor chips.

Many different types of electrical converters make use of press pack modules for their easiness to stack them into a series connection with the help of a mechanical clamping system. To facilitated mechanical clamping, for example, the press pack module is divided into submodules. Each submodule may contain an identical predefined number of chips. The current rating is obtained by paralleling a required number of submodules. In this module design, many chips are set in parallel electrically as well as mechanically. To work properly, this kind of press pack module needs to provide a uniform distribution of a clamping force over all the chips present in the module. One possible solution is to rely on a relatively complex and expensive individual spring system, that is, using one spring per semiconductor chip. Another possibility is to rely instead on very tight mechanical tolerances, which is also costly and complicates a stack assembly.

Such press pack modules are designed in such a way that, to connect their collector and emitter terminals, they need to be clamped in a mechanical stack. This concept offers the possibility of very low contact resistances and high current carrying capabilities. However, to do so the module should provide a uniform distribution of the clamping force over all the semiconductor chips. If the clamping force is not evenly distributed, one chip may carry more current than the others which will significantly reduce the module capability and its lifetime. In addition, if the press pack module is not perfectly flat or does not compensate for uneven flatness, its ability to be stacked will be greatly reduced, and the probability that the semiconductor chips may crack is greatly increased. This is limiting the number of modules which can be put into one stack.

In the semiconductor chip package described herein, a spring-like structure, that is, the at least one compensation layer, is used to uniformly distribute a clamping force over all the semiconductor chips present in the chip package or in a module comprising the chip package.

This chip package allows for the removal of the costly multi-spring package used in other solutions while keeping the package's stacking robustness.

In summary, using the chip package described herein, for example, in a submodule design, one or more compensation layers are used. The at least one compensation layer may have the following properties, individually or in any combination:
- The compensation layer is resilient in order to compensate for the uneven flatness and the thickness differences from the different parts included in the submodule assembly, for example, the semiconductor chips having varying heights.
- The compensation layer may also have a spring-like capability to generate a predefine force on the respective semiconductor chip after it has deformed to compensate for assembly tolerances.
- The compensation layer may also be a good thermal and electric conductor. Metals like copper or aluminum are good electric and thermal conductors, however, in their normal massive form they lack the flexibility and the spring-like effect.

The latter two properties can be introduced in, for example, the metal of the at least one compensation layer by generating a highly porous structure in them. In addition to get the spring-like effect, all the pores can be longitudinally elongated and may be oriented in a predefine direction. The exact orientation of the longitudinal pores may be defined depending on a spring constant needed for the specific application. The number of pores introduced in the metal is, for example, a compromise between compliance to uneven flatness and conduction properties.

According to at least one embodiment, wherein the chip package further comprises a base plate. For example, the base plate is of a metal like copper or aluminum or molybdenum. To avoid oxide layers hindering electric contact, the base plate may be provided with a coating containing nickel and/or a phosphate, for example, so-called NiP. The same applies for the at least one compensation layer.

According to at least one embodiment, the semiconductor chips are located directly between the base plate and the at least one first compensation layer. Hence, the semiconductor chips may be in physical contact with the base plate and the at least one first compensation layer, and there can be contacted by means of a dry contact, that is, without a solder, sinter layer or the like.

Here and in the following, the 'first' compensation layer is the at least one compensation layer being in direct contact with the semiconductor chips. There can be further, compensation layers, too. All the mechanical, electrical and thermal properties discussed below with reference to the first compensation layer may also apply for other compensation layers, like a second compensation layer and a third compensation layer, and vice versa.

According to at least one embodiment, the base plate is a rigid, inelastic plate. "Rigid, inelastic" shall refer to proper or normal use of the chip package. For example, compared with the at least one compensation layer, the base plate has a Young's modulus exceeding the Young's modulus of the at least one compensation layer by at least a factor of three or by at least a factor of ten. Here and in the following, the respective Young's modulus may be seen along a direction perpendicular to a side of the base plate the semiconductor chips are arranged on, or along a direction perpendicular to top sides of the semiconductor chips. Hence, relative to the base plate, the at least one compensation layer can be considered as being soft, and only the respective compensation layer, and not the base plate, may be deformed, for example, elastically deformed.

According to at least one embodiment, the at least one compensation layer and the base plate are configured to be pressed together, with the semiconductor chips between. For example, a pressure used to press the at least one compensation layer and the base plate together is at least 0.1 MPa or at least 0.3 MPa or at least 1 MPa. Alternatively or additionally, this pressure is at most 15 MPa or at most 3 MPa. The pressure may be calculated as the clamping force between the respective base plate and compensation layer, dived by the sum of the cross-sectional area of all the assigned semiconductor chips, the cross-sectional area being perpendicular to the clamping force.

According to at least one embodiment, the chip package further comprises at least one post. For example, the post is of at least one metal. Compared with the at least one compensation layer, the at least one assigned post may be rigid. For example, the at least one post has a Young's modulus exceeding the Young's modulus of the at least one compensation layer by at least a factor of three or by at least a factor of ten.

According to at least one embodiment, the chip package comprises the at least one second compensation layer. The at least one second compensation layer may also comprises the pores and may be mechanically as well as electrically and thermally configured identically or similarly to the at least one first compensation layer. For example, the Young's moduli of the at least one second compensation layer and of the at least one first compensation layer differ by at most a factor of 1.5 or by at most a factor 1.2. It is possible that the at least one second compensation layer and the at least one first compensation layer differ from one another intentionally so that said factor is at least 1.2 or at least 1.5 and/or at most 5 or at most 2.

If there is a post and the at least one second compensation layer, then it is possible that the post is located between the at least one second compensation layer and the at least one first compensation layer. Hence, the at least one second compensation layer may be that at least one compensation layer that is arranged on a side of the at least one post remote from the at least one first compensation layer. According to at least one embodiment, the chip package comprises the at least one third compensation layer. The at least one third compensation layer may also comprises the pores and may be mechanically as well as electrically and thermally configured identically or similarly to the at least one first compensation layer and/or identically or similarly to the at least one second compensation layer. For example, the Young's moduli of the at least one third compensation layer and of the at least one first compensation layer differ by at most a factor of 1.5 or by at most a factor 1.2. It is possible that the at least one third compensation layer and the at least one first compensation layer differ from one another intentionally so that said factor is at least 1.2 or at least 1.5 and/or at most 5 or at most 2.

For example, the at least one third compensation layer is that at least one compensation layer that is located on a side of the semiconductor chips remote from the at least one first compensation layer, for example, on a side of the base plate remote from the semiconductor chips.

According to at least one embodiment, the pores are of non-spherical shape. For example, the pores are at least one of: cylindrical shape, ellipsoidal shape, shape of a cylinder with rounded bottom and top. Hence, the pores may have a pillar-like or column-like shape. It is possible that all the pillars are of the same shape or that there is an intentional variation of the shapes of the pillars. For example, spherical pores may be combined with cylindrical pores.

According to at least one embodiment, an aspect ratio of the pores is at least 1.5 or at least 4 and/or is at most 20 or at most 10 or at most 5. For example, the aspect ratio of a specific pore may be the longest extent of said pore, along a straight line, divided by the maximum lateral extent in a direction perpendicular to the longest extent, the longest extent is larger than or equal to the maximum lateral extent.

According to at least one embodiment, the pores are aligned in parallel with each other. This may mean that the axes of the longest extents of the pores point away from the closest semiconductor chips. For example, said axes are in parallel with each other with a tolerance of at most 30° or of at most 20° or of at most 10°. Alternatively or additionally, said axes, or at least some of said axes, are oriented perpendicular to a sides of base plate the semiconductor chips are arranged on, for example, with a tolerance of at most 30° or of at most 20° or of at most 10°.

According to at least one embodiment, a volume proportion of the pores on the overall respective compensation layer is at least 5% or at least 10% or at least 20%. Alternatively or additionally, said proportion is at most 80% or at most 70% or at most 60% or at most 45% or at most 30%. For example, said proportion is between 10% and 60% inclusive or between 10% and 30% inclusive. Hence, the volume proportion can be comparably small.

According to at least one embodiment, in a direction towards the semiconductor chips, the at least one compensation layer has a Young's modulus of at least 1 GPa or of at least 2 GPa or of at least 5 GPa. Alternatively or additionally, said Young's modulus is at most 60 GPa or is at most 40 GPa or is at most 20 GPa or is at most 10 GPa.

A chip package described herein is explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figures 1 and 2: are schematic sectional views of exemplary embodiments of chip packages described herein,
- Figures 3 and 4: are schematic sectional views of exemplary embodiments of first compensation layers for chip packages described herein,
- Figure 5: is a schematic sectional view of an exemplary embodiment of a chip package described herein, and
- Figure 6: is a schematic top view of an exemplary embodiment of a chip package described herein.

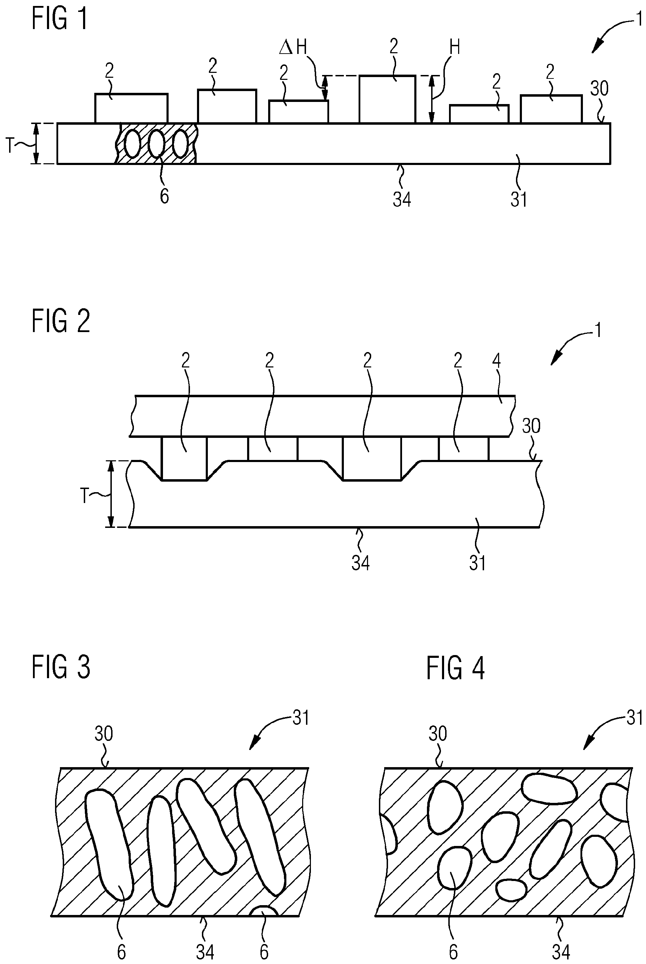

Figure 1 illustrate an exemplary embodiment of a chip package 1. The chip package 1 comprises a first compensation layer 31 and a plurality of semiconductor chips 2 which are arranged on a mounting side 30 of the first compensation layer 31.

For example, the semiconductor chips 2 are selected from the following group: a metal-oxide-semiconductor field-effect transistor (MOSFET), a metal-insulator-semiconductor field-effect transistor (MISFET), an insulated-gate bipolar transistor (IGBT), a bipolar junction transistor (BJT), and a junction gate field-effect transistor (JFET), a thyristor like a gate turn-off thyristor (GTO) or a gate commutated thyristor (GCT), a diode.

For example, the semiconductor chips 2, or at least one or some of the semiconductor chips 2, are configured for a maximum current of at least 1 A or of at least 20 A. Alternatively or additionally, the semiconductor chips 2 are configured for a maximum voltage of at least 0.2 kV or of at least 0.6 kV or of at least 1.2 kV. In other words, the semiconductor chips 2 could be power semiconductor chips.

The chip package 1 is, for example, for a power module in a vehicle to convert direct current from a battery to alternating current for an electric motor, for example, in hybrid vehicles or plug-in electric vehicles or in a train. Moreover, the power semiconductor device can be a fuse, for example, in a vehicle like a car. It is also possible that the chip package 1 is used in power switches like transformers. The chip package 1 may be a press pack module or part of a press pack module.

All the semiconductor chips 2 may be of the same kind. In this case, due to manufacturing tolerances, the semiconductor chips 2 can have different heights H. Hence, there can be height differences ΔH between semiconductor chips 2. Different heights H above the mounting side 30 may also result from an unevenness or roughness of the mounting side 30. Further, it is possible that different kinds of semiconductor chips 2 are used. For example, IGBTs and diodes can be used in combination to account for different current directions through the chip package. Using different kinds of semiconductor chips 2 may result in comparably large height differences ΔH.

For example, the height differences ΔH amount to at least 1% or at least 5% or at least 10% of a maximum height H of the semiconductor chips 2. Alternatively or additionally, said height differences ΔH amount to at most 70% or to at most 50% or to at most 30% of the maximum height H of the semiconductor chips 2.

For example, the maximum height H is at least 0.1 mm or at least 0.4 mm. Alternatively or additionally, said maximum height H is at most 2 mm or at most 0.7 mm or at most 0.5 mm. For example, the maximum height H is between 0.2 mm and 0.5 mm inclusive.

The first compensation layer 31 is configured to compensate for the height differences ΔH when the semiconductor chips 2 are pressed to another component, not shown in Figure 1, to electrically contact them by means of, for example, a dry contact. Accordingly, the first compensation layer 31 needs to be mechanically deformable to allow contacting all the sides of the semiconductor chips 2 facing away from the mounting side 30 by means of an even, hard surface. The first compensation layer 31 also needs to maintain a pressure on the semiconductor chips 2. Hence, the first compensation layer 31 needs to be elastically deformable, like a spring.

For this purpose, the first compensation layer 31 has an internal structure. For example, the inner structure of the first compensation layer 31 is like a foam. Hence, the first compensation layer 31 may comprise a plurality of pores 6. For example, a volume proportion of the pores on the overall first compensation layer 31 is at least 5% or at most 80% and may be between 10% and 60% inclusive or between 10% and 30% inclusive.

Because the semiconductor chips 2 can be power semiconductor chips, the volume proportion may be comparably small to enable high current-carrying properties und to achieve efficient cooling of the semiconductor chips 2 through the first compensation layer 31. For example, the first compensation layer is configured for a current density of at least 1 A/cm² or of at least 5 A/cm² or of at least 10 A/cm² or at least 50 A/cm². These current densities may refer to a direction perpendicular to a back side 34 of the first compensation layer 31, opposite the mounting side 30. The back side 34 may be of planar fashion.

For example, a maximum thickness T of the first compensation layer 31 is at least 0.2 mm or at least 0.3 mm or at least 0.8 mm. Alternatively or additionally, said thickness T is at most 5 mm or at most 3 mm or at most 1.5 mm. For example, said thickness is between 0.3 mm and 3 mm inclusive. Hence, the thickness T of the at least one first compensation layer is, for example, between 0.2 mm and 5 mm inclusive, and a minimum diameter of the at least one first compensation layer may exceed the thickness T by at least a factor of 3.

The first compensation layer 31 can be of disk-shape. This may mean that the first compensation layer 31 has a width much greater than the thickness H. For example, a minimum diameter of the first compensation layer 31 exceeds the thickness T by at least a factor of 3 or at least a factor of 10 or at least a factor of 30. Alternatively or additionally, said factor is at most 300 or at most 100. In case of a square first compensation layer 31, seen in top view of the back side 34, the minimum diameter may be an edge length, in case of a rectangular back side 34 the minimum diameter may be a shortest edge length. Otherwise, the minimum diameter d may be calculated from an area content A of the back side 34 as follows: d = (4 A/π)^{0,5}.

According to at least one embodiment, the height differences ΔH amount to at least 1% or to at least 5% and/or to at most 70% or to at most 50% or to at most 30% or to at most 15% of the thickness T of the first compensation layer 31. For example, the height differences ΔH amount to between 1% and 30% inclusive of the thickness T of the at least one first compensation layer 31.

According to at least one embodiment, the first compensation layer 31 is of pure copper or of pure aluminum or of pure molybdenum. The term 'pure' may mean that the first compensation layer 31 is of at least 99% or of at least 99.8% by mass of the respective metal. Hence, the mechanical properties of the first compensation layer 31 are achieved by means of its internal structure, that is, the pores 6, and not or not essentially by means of alloys. Alloying, for example, Al with Be may decrease the Young's modulus in a desired manner, by may also drastically decrease the electrical conductivity. Hence, when using, for example, power semiconductor chips 2, such alloys should be avoided to keep the electrical conductivity of the first compensation layer 31 as high as desired. Alternatively, any other metal or metal alloy with good electrical conductivity could be used for the first, second and/or third compensation layers 31, 32, 33.

In Figure 2, another exemplary embodiment of the chip package 1 is illustrated. In this case, the chip package 1 also includes a base plate 4. The base plate 4 is, for example, a massive metal plate made of, for example, copper or molybdenum or aluminum. Hence, the base plate 4 may be free of any inner structure but may be a homogeneous piece of metal.

Accordingly, the base plate 4 is much more rigid and inflexible than the first compensation layer 31. When the semiconductor chips 2 are electrically and thermally contacted by means of pressing the first compensation layer 31 and the base plate 4 together, then essentially only the first compensation layer 31 deforms but not the base plate 4.

That is, the height differences of the semiconductor chips 2 are compensated for by the first compensation layer 31 by pressing the semiconductor chips 2 into the mounting side 30 of the first compensation layer 31. In this pressing, the back side 34 may be supported by an additional layer, not shown, so that the back side 34 may still be of planar and even fashion.

Accordingly, by using the first compensation layer 31 the height differences between the semiconductor chips 2 can be compensated for by a single component, so that individual springs assigned to the semiconductor chips 2, for example, in a one-to-one manner can be omitted.

Otherwise, the same as to Figure 1 may also apply to Figure 2 .

In Figures 3 and 4, possible configurations of the first compensation layer 31 are illustrated. In all these configurations it is possible that the mounting side 30 and the planar back side 34 are free of the pores 6. Hence, the mounting side 30 and the planar back side 34 can be free of any voids or holes resulting from the pores 6. Otherwise, there may be few pores 6 running to the mounting side 30 or to the back side 34, but, for example, at least 90% or at least 95% or at least 98% of the mounting side 30 and/or of the back side 34 are free of the pores 6. It is possible that there is no continuous pore or hole running from the mounting side 30 to the planar back side 34.

The mounting side 30 and/or the back side 34 may be provided with a coating, not shown, for example, to avoid electrically insulating oxide films on these sides.

According to Figure 3, the pores 6 are of elongated fashion. Thus, an aspect ratio of the pores 6 may be at least 1.5 or at least 4 and/or is at most 20 or at most 10 or at most 5 and may be between 1.5 and 10 inclusive. It is possible that all of the pores 6 are of about the same shape, like cylindrical or ellipsoidal.

For example, there is only one layer of pores 6 in the direction perpendicular to the back side 34. All the pores 6, or most of the pores 6, may be aligned in parallel or about in parallel with each other. The term 'about' may mean a tolerance of at most 30° or of at most 20° or of at most 10°.

As an option, a longest extent of said pore, along a straight line, for example, perpendicular to or about perpendicular to the back side 34, amounts to at least 60% or to at least 70% and/or to at most 95% or to at most 80% of the thickness of the first compensation layer 31. Hence, the pores 6 may nearly completely run through the first compensation layer 31, but without reaching the mounting side 30 and the back side 34 to allow for good thermal and electric contact.

Such first compensation layers 31 may be produced, for example, by mixing metallic particles and organic particles of appropriate size and then baking or melting the metallic particles together while the organic particles vanish. Then the resulting material may anisotropically be stretched to get the elongated pores 6. By appropriately choosing the sizes of the metallic and organic particles and the volume proportions, the properties of the first compensation layer 31 can be adjusted.

For example, a mean diameter of the pores 6 is at least 0.1 mm or at least 0.3 mm and/or at most 2 mm or at most 1.2 mm and may be between 0.1 mm and 2 mm inclusive. For example, said mean diameter dm may be calculated from a volume V of the respective pore 6 by: dm = (6 V/π)^{1/3}.

In Figure 4 it is illustrated that there can be more than one layer of the pores 6. For example, there are two layer of the pores 6 one above the other, on average. Further, the pores 6 may have a greater size variation and/or shape variation.

Otherwise, the same as to Figures 1 and 2 may also apply to Figures 3 and 4, and vice versa.

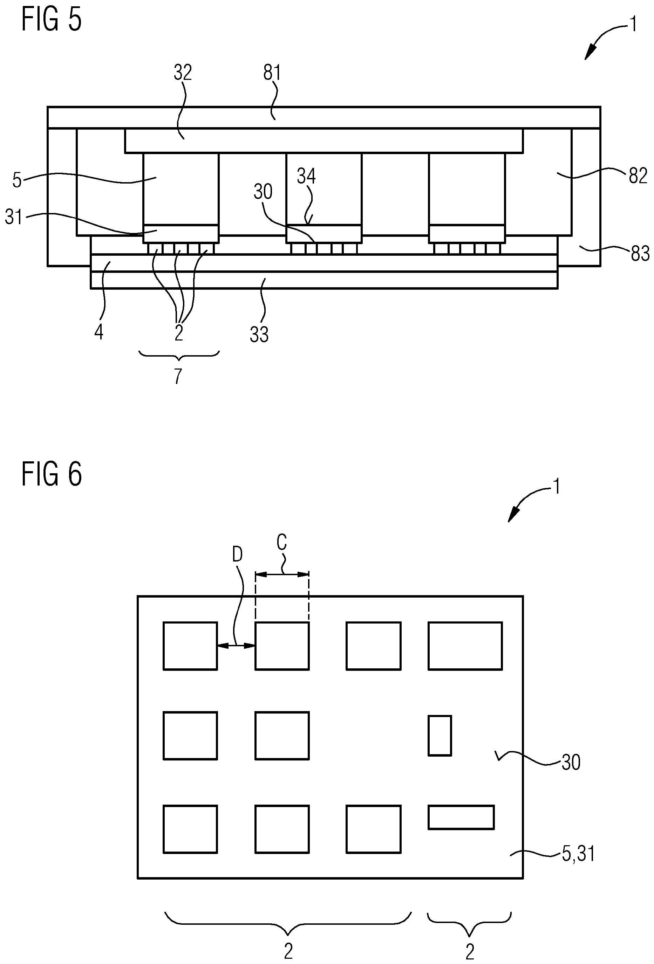

In Figure 5, a more complex exemplary embodiment of the chip package 1 is illustrated. For example, the chip package 1 comprises a plurality of submodules 7. Each one of the submodules 7 may comprise one or a plurality of the semiconductor chips 2. For example, per submodule 7 there are at least six or at least nine and/or at most 36 or at most 16 of the semiconductor chips 2.

Moreover, each one of the submodules 7 may include its own first compensation layer 31 so that the chip package 1 comprises a plurality of the first compensation layers 31, and on each one of the first compensation layers 31 there are some of the semiconductor chips 2.

As an option, the submodules 7 may include posts 5. The posts 5 are, for example, of a massive metallic block which can be of copper or aluminum or molybdenum, for example. Hence, similar to the base plate 4, the posts 5 are rigid compared with the first compensation layers 31. It is possible that there is a one-to-one assignment between the posts 5 and the first compensation layers 31. The posts 5 may be in each case in direct contact with the back sides 34 of the first compensation layers 31.

The posts 5 and the first compensation layers 1 may optionally be applied in an interior holder 82 to avoid getting out of place of the posts 5 and the first compensation layers 1. As a further option, the chip package 1 could include a module frame 83 which is, for example, made of a ceramic. The module frame 83 may be of ring shape, seen in top view of the back sides 34.

It is possible that the base plate 4 is a common base plate for all the submodules 7. Hence, all the first compensation layers 31 can be located directly on the base plate 4. Otherwise, there can be a base plate 4 for each one of the submodules 7 or for groups of the submodules 7.

Moreover, it is possible that there is a second compensation layer 32. The second compensation layer 32 may be directly on a side of the post 5 remote from the first compensation layers 31. All the submodules 7 can be located on the same second compensation layer 32, or there is a plurality of the second compensation layers 32, other than illustrated.

As a further option, the chip package 1 may include a cover plate 81 on top of the second compensation layer 32. For example, the cover plate 81 is a common plate covering all the submodules 7, and may be an emitter contact for the semiconductor chips 2. Consequently, the base plate 4 may be a drain contact or a collector contact. By means of the second compensation layer 32, a homogeneous pressure and clamping force can be applied on all the posts 5, and the first compensation layers 31 may be prevented from damage from the side of the posts 5.

As a further option, the chip package 1 may alternatively or additionally include a third compensation layer 33. For example, the third compensation layer 33 is located on a side of the base plate 4 remote from the semiconductor chips 2. By having the third compensation layer 33, a homogeneous pressure and clamping force can be applied on the base plate 4.

All the compensation layers, that is, the first compensation layers 31, the second compensation layer 32 and the third compensation layer 33, can have the same inner structure, that is, the same kind of pores 6, the same material and the same thickness. Hence, the only differences between the compensation layers 31, 32, 33 may be there lateral dimensions or edge lengths.

Otherwise, it possible that the compensation layers 31, 32, 33 have intended different mechanical properties. For example, the larger second and third compensation layers 32, 33 may be more rigid than the first compensation layers 31 in order to allow for larger pressure gradients on the cover plate 81 and/or on the base plate 4.

For example, in a direction towards the semiconductor chips 2 and/or perpendicular to the back sides 34, the compensation layers 31, 32, 33 each have a Young's modulus of between 2 GPa and 20 GPa inclusive. It is possible that the first compensation layers 31 are configured for an elastic thickness gradient of at least 50 µm or of at least 0.1 mm or of at least 0.3 mm thickness variation per 1 mm lateral length. That is, over a distance of 1 mm in a direction parallel to the back side 34, a thickness difference of at least 50 µm can be compensated for. Hence, the semiconductor chips 2 may be packed relatively closely on the first compensation layers 31. Concerning the enabled thickness gradient, the same may apply to the second and third compensation layers 32, 33.

It is possible that in the chip package 1 there are only dry contacts. Hence, between the semiconductor chips 2, the compensation layers 31, 32, 33, the base plate 4, the posts 5 and the cover plate 81 there are no solder layers or sinter layers, but these components are electrically connected by pressure only. Springs or clamps providing such a pressure may be within the chip package 1 or may be external components, not shown.

Otherwise, the same as to Figures 1 to 4 may also apply to Figure 5, and vice versa.

In Figure 6, a top view of another exemplary embodiment of the chip package 1 is shown. On the mounting side 30, there is the plurality of semiconductor chips 2 arranged, for example, in a regular grid. There can be different types of the semiconductor chips 2, like IGBTs and diodes, having different thicknesses.

The semiconductor chips 2 may have an edge length L. For example, the edge length L is at least 0.2 mm and/or at most 2 mm or at most 2 cm. A distance D between adjacent semiconductor chips 2 may be smaller than the edge length L. For example, said distance D may amount to at least 10% or at least 25% and/or to at most 100% or to at most 80% or to at most 65% of the edge length L.

Otherwise, the same as to Figures 1 to 5 may also apply to Figure 6, and vice versa.

The components shown in the figures follow, unless indicated otherwise, preferably in the specified sequence directly one on top of the other. Components which are not in contact in the figures are preferably spaced apart from one another. If lines are drawn parallel to one another, the corresponding surfaces are preferably oriented in parallel with one another. Likewise, unless indicated otherwise, the positions of the drawn components relative to one another are correctly reproduced in the figures.

The chip package described here is not restricted by the description on the basis of the exemplary embodiments. Rather, the chip package encompasses any new feature and also any combination of features, which includes in particular any combination of features in the patent claims, even if this feature or this combination itself is not explicitly specified in the patent claims or exemplary embodiments.

### List of Reference Signs

- 1: chip package
- 2: semiconductor chip
- 30: mounting side
- 31: first compensation layer
- 32: second compensation layer
- 33: third compensation layer
- 34: planar back side
- 4: base plate
- 5: post
- 6: pore
- 7: submodule
- 81: cover plate
- 82: interior holder
- 83: module frame
- D: distance between the semiconductor chips
- ΔH: height difference between semiconductor chips
- H: maximum height of the semiconductor chips
- L: edge length of the semiconductor chips
- T: thickness of the first compensation layer

## Claims

1. A chip package (1) comprising:
- at least one first compensation layer (31) which is electrically conductive, and
- a plurality of semiconductor chips (2) arranged on and electrically contacted by the at least one first compensation layer (31),
wherein
- the at least one first compensation layer (31) comprises a plurality of pores (6), and
- the at least one first compensation layer (31) is elastically deformable so that the at least one first compensation layer (31) is configured to compensate for height differences (ΔH) between the semiconductor chips (2).

2. The chip package (1) according to the preceding claim, further comprising a base plate (4), wherein
- the semiconductor chips (2) are located directly between the base plate (4) and the at least one first compensation layer (31),
- the base plate (4) is a rigid, inelastic plate , and
- the at least one first compensation layer (31) and the base plate (4) are configured to be pressed together, with the semiconductor chips (2) between, with a pressure of between 0.1 MPa and 15 MPa inclusive.

3. The chip package (1) according to any one of the preceding claims,
further comprising at least one post (5) and a second compensation layer (32), wherein
- the at least one post (5) is a rigid, inelastic pillar,
- the second compensation layer (32) also comprises the pores (6) and is elastically deformable so that the second compensation layer (32) is also configured to compensate for the height differences (ΔH) between the semiconductor chips (2),
- the at least one first compensation layer (31) is located between the at least one post (5) and the semiconductor chips (2), and
- the at least one post (5) is mounted on the second compensation layer (32) so that the at least one post (5) is located between the second compensation layer (32) and the at least one first compensation layer (31).

4. The chip package (1) according to any one of the preceding claims,
further comprising a third compensation layer (33), wherein
- the third compensation layer (33) also comprises the pores (6) and is elastically deformable so that the third compensation layer (33) is also configured to compensate for the height differences (ΔH) between the semiconductor chips (2), and
- the third compensation layer (33) is located on a side of the semiconductor chips (2) remote from the at least one first compensation layer (31).

5. The chip package (1) according to any one of the preceding claims,
comprising a plurality of the first compensation layers (31), wherein on each one of the first compensation layers (31) some of the semiconductor chips (2) are arranged, so that the semiconductor chips (2) are grouped in submodules (7) and each one of the submodules (7) comprises one of the first compensation layers (31).

6. The chip package (1) according to any one of the preceding claims,
wherein the at least one first compensation layer (31) comprises a mounting side (30) facing the semiconductor chips (2) and a planar back side (34) opposite the mounting side (30), and
wherein the mounting side (30) and the planar back side (34) are free of the pores (6).

7. The chip package (1) according to any one of the preceding claims,
wherein the at least one first compensation layer (31) is of pure copper or of pure aluminum.

8. The chip package (1) according to any one of the preceding claims,
wherein at least one of
- a thickness (T) of the at least one first compensation layer (31) is between 0.2 mm and 5 mm inclusive, and
- a minimum diameter of the at least one first compensation layer (31) exceeds the thickness (T) by at least a factor of 3.

9. The chip package (1) according to the preceding claim,
wherein the height differences (ΔH) amount to below 70% of the thickness (T) of the at least one first compensation layer (31).

10. The chip package (1) according to any one of the preceding claims,
wherein the height differences (ΔH) amount to below 30% of a maximum height (H) of the semiconductor chips (2).

11. The chip package (1) according to any one of the preceding claims,
wherein at least one of
- the pores (6) are at least one of: cylindrical shape, ellipsoidal shape, shape of a cylinder with rounded bottom and top, and
- an aspect ratio of the pores (6) is between 1.5 and 20 inclusive.

12. The chip package (1) according to the preceding claim,
wherein the pores (6) are aligned in parallel with each other, axes of longest extent of the pores (6) point away from the closest semiconductor chips (2).

13. The chip package (1) according to any one of the preceding claims,
wherein the pores (6) have a mean diameter of between 0.1 mm and 2 mm inclusive, and
wherein a volume proportion of the pores (6) is between 5% and 80% inclusive.

14. The chip package (1) according to any one of the preceding claims,
wherein at least one of
- in a direction towards the semiconductor chips (2), the at least one first compensation layer (31) has a Young's modulus of between 1 GPa and 60 GPa inclusive, and
- the at least one first compensation layer (31) is configured for an elastic thickness gradient of at least 50 µm thickness variation per 1 mm lateral length.

15. The chip package (1) according to any one of the preceding claims,
wherein at least one of
- the semiconductor chips (2) are power semiconductor chips and
- the at least one first compensation layer (31) is configured for a current density of at least 1 A/cm².
